Europäisches Patentamt

European Patent Office

Office européen des brevets

(19)

(11) Veröffentlichungsnummer : **0 110 332**
**B1**

(12) # EUROPÄISCHE PATENTSCHRIFT

(45) Veröffentlichungstag der Patentschrift :
01.02.89

(21) Anmeldenummer : 83111788.2

(22) Anmeldetag : 24.11.83

(51) Int. Cl.⁴ : **H 05 K   1/03**, B 32 B 27/12

(54) **Verfahren zur Herstellung von Laminaten mit niedriger Dielektrizitätskonstante.**

(30) Priorität : 26.11.82 DE 3243925

(43) Veröffentlichungstag der Anmeldung :
13.06.84 Patentblatt 84/24

(45) Bekanntmachung des Hinweises auf die Patenterteilung : 01.02.89 Patentblatt 89/05

(84) Benannte Vertragsstaaten :
DE FR GB IT NL

(56) Entgegenhaltungen :
DE–A– 2 947 112
US–A– 4 292 106

(73) Patentinhaber : **Siemens Aktiengesellschaft Berlin
und München
Wittelsbacherplatz 2
D-8000 München 2 (DE)**

(72) Erfinder : **Hussain, Amir, Dipl.-Chem., Dr. rer. nat.
Bellinzonastrasse 6
D-8000 München 71 (DE)**
Erfinder : **v. Stein, Christian, Dipl.-Ing.
Reinekestrasse 22
D-8000 München 90 (DE)**
Erfinder : **Pflugbeil, Christa, Dipl.-Ing.
Eichendorff-Weg 17
D-8021 Hohenschäftlarn (DE)**
Erfinder : **Schlitter, Hans
Gulbranssonstrasse 43
D-8000 München 71 (DE)**

EP 0 110 332 B1

**Beschreibung**

Verfahren zur Herstellung von Laminaten mit niedriger Dielektrizitätskonstante.

Die Erfindung betrifft ein Verfahren zur Herstellung von Laminaten aus vernetzbarem, thermoplastischen Polyethylen (PE), insbesondere als Ausgangsmaterial für elektrische Leiterplatten mit niedriger Dielektrizitätskonstante, wobei zwischen Glasgewebe eine Folie aus Polymermaterial verpreßt wird.

Leiterbahnen mit hohen Wellenwiderständen sind auf gedruckten Schaltungen leichter herzustellen, wenn das Dielektrikum eine niedrigere Dielektrizitätskonstante als das meist verwendete Epoxid-Prepreg aufweist.

Laminate auf der Basis von Kohlenwasserstoffharzen (Polyethylen, DK = 2,2-2,3) bieten sich auch als günstiges Dielektrikum für gedruckte Schaltungen an, die für hohe Frequenzen bestimmt sind.

Zur Herstellung von Leiterplatten sind zahlreiche Verfahren bekannt. So sind zum Beispiel in dem Buch « Gedruckte Schaltungen » von Seidel, 1959, die grundlegenden Verfahren zur Herstellung gedruckter Schaltungen mit dem gebräuchlichsten Epoxid-Prepreg beschrieben. Üblicherweise wird das Epoxid-Prepreg durch Tränken von Glasgewebe in gelöstem Epoxidsystem und Verdampfen des Lösungsmittels hergestellt. Das Herstellverfahren für Epoxid-Prepreg ist sehr aufwendig.

Als Ausgangsmaterial für die Herstellung elektrischer Leiterplatten ist es auch bekannt, eine Glasfaserschicht zu verwenden, auf der eine Polyethylenschicht aufgebracht ist (US-PS 4 292 106).

In der DE-OS 29 47 112 werden vernetzbare, überzogene Platten oder Bögen und hieraus gebildete Schichtgebilde beschrieben und dargestellt. Als Grundmaterial dient z. B. ein Glastuch, auf dem eine Harzmasse mittels einer Heißwalze aufgebracht wird. Damit können Kompositionsbögen von verschiedenen Formen, wie homogene Bögen, Bögen worin das Grundmaterial auf einer Oberfläche desselben liegt und u. a. Bögen, worin das Grundmaterial auf beiden Oberflächen desselben liegt, erhalten werden.

Der Erfindung liegt die Aufgabe zugrunde, ein Ausgangsmaterial für elektrische Leiterplatten zu schaffen, das eine möglichst niedrige Dielektrizitätskonstante aufweist und dessen Herstellung einfach und dessen Verarbeitungsparameter problemlos in engen Grenzen konstant gehalten werden können.

Diese Aufgabe wird mit dem eingangs definierten Verfahren dadurch gelöst, daß das PE mit einem Antioxidans und Kupfer-Desaktivator sowie mit Peroxid versehen wird und Folien zwischen 60 μm und 200 μm Verwendung finden, daß als Glasgewebe ein Gewebetyp mit einem Flächengewicht zwischen 35 und 200 g/m² Verwendung findet, daß die Folien bei Temperaturen von 150 °C und 180 °C in zwei Stufen unter Druck zu einem Prepreg verpreßt werden und daß ferner für die Kaschierung des Prepregs eine 35 μm starke und mit einer Haftschicht versehene Kupferfolie benutzt wird.

Mit einem derartigen Ausgangsstoff lassen sich elektrische Leiterplatten im Gegensatz zu herkömmlichen Verfahren einfach herstellen, weil durch die Verwendung einer Folie, die gleichmäßig hergestellt wird, die Beschaffenheit des Endproduktes positiv zu beeinflussen ist. Außerdem sind damit die Herstellungs- und Verarbeitungsparameter konstant zu halten. Durch die niedrigere Dielektrizitätskonstante können für den gleichen Wellenwiderstand dünnere Leiterplatten hergestellt werden, als es mit den herkömmlichen dielektrischen Isoliermaterialien möglich ist.

Nach einer Weiterbildung der Erfindung sind mehrere Glasgewebelagen abwechselnd mit mehreren Folien aus Polymermaterial verpreßt. Durch diese Anordnung ist die gleichmäßige Verteilung des Polymermaterials während des Verpressens gewährleistet.

Bisher wurde das Glasgewebe immer mit einem Polymer vorimprägniert. Nach der Erfindung kann man Glasgewebe auch unbeschichtet bzw. mit Folien aus vernetzbarem Polyethylen extrusionsbeschichtet verpressen.

Nach einer Ausgestaltung der Erfindung können vor dem Verpressen zwischen die Glasgewebelagen und das Polymermaterial Folien aus einem Copolymer aus Polyethylen mit endständigen Epoxid- bzw. Anhydridgruppen gelegt werden. Durch die Verwendung von Folien aus Copolymer wird die Haftung zwischen Verbundstoffen wesentlich verbessert.

Nach einer weiteren Ausgestaltung der Erfindung wird das Glasgewebe mit einem Silanhaftvermittler versehen. Dadurch wird eine Bindung zwischen dem Glasgewebe und dem Polyethylen hergestellt.

Für die Durchführung der Erfindung wurden Folien und Prepregs aus vernetzbarem Polyethylen nach dem Extrusionsverfahren hergestellt. Die Dicken der einzelnen Sorten betragen zwischen 60 μm und 200 μm. Das Verstärkungsmaterial für die Laminate, das heißt, das Glasgewebe, ist mit Epoxi-Silan-Haftvermittler versehen. Als Glasgewebe findet ein Gewebetyp mit einem Flächengewicht zwischen 35 und 200 g/m² Verwendung. Mehrere Lagen von Polyethylen-Folien und Glasgewebe werden bei Temperaturen von 150 °C und 180 °C in zwei Stufen unter Druck verpreßt. Um die Haftung zwischen dem Glasgewebe und dem Polyethylen zu verbessern, können vor dem Verpressen dünne Folien « Igetabond » (Handelsname) zwischen das Glasgewebe und die vernetzbare Polyethylenfolie gelegt werden. Die Vernetzung von Polyethylen wird durch das Peroxid, das neben dem Antioxidans und Kupfer-Desaktivator in kleinen Mengen in Polyethylen vorhanden ist, beim Verpressen ausgelöst. Für die Kaschierung des Prepregs wird eine 35 μm starke und mit einer Haftschicht versehene Kupferfolie benutzt. Laminate nach der Erfindung haben die für die herkömmlichen Leiterplatten erforderlichen Tests gut bestanden.

**Patentansprüche**

1. Verfahren zur Herstellung von Laminaten aus vernetzbarem, thermoplastischem Polyethylen (PE), insbesondere als Ausgangsmaterial für elektrische Leiterplatten mit niedriger Dielektrizitätskonstante, wobei zwischen Glasgewebe eine Folie aus Polymermaterial verpreßt wird, dadurch gekennzeichnet, daß das PE mit einem Antioxidans und Kupfer-Desaktivator sowie mit Peroxid versehen wird und Folien zwischen 60 µm und 200 µm Verwendung finden, daß als Glasgewebe ein Gewebetyp mit einem Flächengewicht zwischen 35 und 200 g/m² Verwendung findet, daß die Folien bei Temperaturen von 150 °C und 180 °C in zwei Stufen unter Druck zu einem Prepreg verpreßt werden und daß ferner für die Kaschierung des Prepregs eine 35 µm starke und mit einer Haftschicht versehene Kupferfolie benutzt wird.

2. Verfahren nach Anspruch 1, dadurch gekennzeichnet, daß mehrere Glasgewebelagen abwechselnd mit mehreren Folien aus Polymermaterial verpreßt werden.

3. Verfahren nach Anspruch 1 und 2, dadurch gekennzeichnet, daß die Glasgewebelagen unbeschichtet bzw. mit Folien aus vernetzbarem PE extrusionsbeschichtet verpreßt werden.

4. Verfahren nach den Ansprüchen 1 und 2, dadurch gekennzeichnet, daß vor dem Verpressen zwischen die Glasgewebelagen und das Polymermaterial Folien aus einem Copolymer aus PE mit endständigen Epoxid- bzw. Anhydrigruppen gelegt werden.

5. Verfahren nach Anspruch 4, dadurch gekennzeichnet, daß das Glasgewebe mit einem Silanhaftvermittler auf Epoxidbasis versehen wird.

**Claims**

1. A method of producing laminates from cross-linkable, thermoplastic polyethylene (PE), in particular as the starting material for electrical circuit boards of low dielectric constant, a film of polymer material being pressed between glass fabrics, wherein the PE is provided with an antioxidant and a copper deactivator and with peroxide and the films used are between 60 µm and 200 µm, wherein the glass fabrics used are of a fabric type having a basis weight between 35 and 200 g/m² wherein the films are pressed to form a prepreg in two steps under pressure at temperatures from 150 °C to 180 °C, and wherein, furthermore, a 35 µm thick copper foil provided with an adhesive coating is used for lamination of the prepreg.

2. The method as claimed in claim 1, wherein several layers of glass fabric are pressed alternately with several films of polymer material.

3. The method as claimed in claim 1 and 2, wherein the layers of glass fabric are pressed in the uncoated state or after extrusion coating with films of cross-linkable PE.

4. The method as claimed in claims 1 and 2, wherein films made from a copolymer of PE containing terminal epoxide or anhydride groups are placed between the layers of glass fabric and the polymer material before pressing.

5. The method as claimed in claim 4, wherein the glass fabric is provided with an epoxide-based silane adhesion promoter.

**Revendications**

1. Procédé de fabrication de stratifiés en polyéthylène (PE) thermoplastique, réticulable, notamment comme matière de départ pour des plaquettes de circuits imprimés de faible constante diélectrique, en comprimant une feuille de matière polymère entre deux tissus de verre, caractérisé en ce qu'il consiste à munir le PE d'un agent antioxydant et d'un désactivateur de cuivre, ainsi que d'un peroxyde et à utiliser des feuilles comprises entre 60 µm et 200 µm, à utiliser comme tissu de verre un type de tissu ayant un poids par unité de surface compris entre 35 et 200 g/m², à comprimer les feuilles sous pression en un préimprégné à des températures de 150 °C et 180 °C en deux stades et à utiliser en outre, pour le placage du préimprégné, une feuille de cuivre de 35 µm d'épaisseur et munie d'une couche d'adhésif.

2. Procédé suivant la revendication 1, caractérisé en ce qu'il consiste à comprimer plusieurs couches de tissu de verre alternativement avec plusieurs feuilles en matière polymère.

3. Procédé suivant la revendication 1 ou 2, caractérisé en ce qu'il consiste à comprimer les couches de tissu de verre non revêtues ou revêtues par extrusion de feuilles en PE réticulable.

4. Procédé suivant les revendications 1 et 2, caractérisé en ce qu'il consiste à interposer avant la compression, entre les couches de tissu de verre et la matière polymère, des feuilles en un copolymère de PE à groupes époxydiques ou anhydrides terminaux.

5. Procédé suivant la revendication 4, caractérisé en ce qu'il consiste à munir le tissu de verre d'un agent de pontage silanique à base d'époxyde.